# EUROPÄISCHE PATENTSCHRIFT

(11) **EP 3 262 667 B1**
(45) Veröffentlichungstag und Bekanntmachung des Hinweises auf die Patenterteilung: **06.01.2021**
(21) Anmeldenummer: 16708957.2
(22) Anmeldetag: 25.02.2016
(51) Int. Cl.: H01G 4/232, H01G 4/38, H01G 2/06, H05K 1/18, H05K 3/34

(54) **ELEKTRISCHER ANSCHLUSSKONTAKT FUER EIN KERAMISCHES BAUELEMENT, KERAMISCHES BAUELEMENT, BAUELEMENTANORDNUNG UND VERFAHREN ZUR DEREN HERSTELLUNG**
ELECTRICAL TERMINAL FOR A CERAMIC COMPONENT, CERAMIC COMPONENT, COMPONENTS ASSEMBLY AND METHOD FOR MANUFACTURING IT
TERMINAL ELECTRIQUE POUR COMPOSANT EN CERAMIQUE, COMPOSANT EN CERAMIQUE, ENSEMBLE DE COMPOSANTS ET PROCÉDÉ DE MANUFACTURE

(30) Priorität: 27.02.2015 DE 102015102866
(43) Veröffentlichungstag der Anmeldung: 03.01.2018
(73) Patentinhaber: TDK Electronics AG, 81671 München (DE)
(72) Erfinder: KOINI, Markus, 8054 Seiersberg (AT); AUER, Christoph, 8043 Graz (AT); KONRAD, Jürgen, 8042 Graz (AT); RINNER, Franz, 8530 Deutschlandsberg (AT); PUFF, Markus, 8010 Graz (AT); STADLOBER, Monika, 8055 Graz (AT); WIPPEL, Thomas, 8510 Stainz (AT)
(74) Vertreter: Epping - Hermann - Fischer
(86) Internationale Anmeldenummer: PCT/EP2016/054007
(87) Internationale Veröffentlichungsnummer: WO 2016/135255

(56) Entgegenhaltungen:
- EP-A2- 0 929 087
- EP-A2- 2 587 502
- DE-A1-102013 108 753
- US-A- 5 712 758
- US-A- 6 081 416
- US-A1- 2009 147 440

## Beschreibung

Es wird ein Anschlusskontakt für ein keramisches Bauelement angegeben. Der Anschlusskontakt ist beispielsweise aus einem Blech gebildet. Insbesondere kann der Anschlusskontakt als Leadframe oder Anschlusswinkel ausgebildet sein.

Keramische Bauelemente benötigen zur Verschaltung in elektronischen Systemen, z. B. mittels einer Leiterplatte, eine elektrische Kontaktierung. Typischerweise werden Außenkontakte des keramischen Bauelementes durch ein Lotmaterial mit den Kontaktstellen einer Leiterplatte verbunden. In der Leistungselektronik besteht eine besondere technische Herausforderung darin, eine thermomechanisch stabile Anbindung zu realisieren, die gleichzeitig eine möglichst gute elektrische und thermische Leitfähigkeit sowie ein gutes Hochfrequenzverhalten bietet.

In der DE 10 2013 108 753 A1 ist ein keramisches Bauelement mit einem Anschlusselement beschrieben. In der US 6 081 416 A ist ein keramisches Bauelement mit einem Anschlusselement beschrieben, dessen thermischer Ausdehnungskoeffizient kleiner ist als der Ausdehnungskoeffizient der Keramik.

Es ist eine Aufgabe der vorliegenden Erfindung, einen verbesserten Anschlusskontakt für ein keramisches Bauelement anzugeben.

Ein keramisches Bauelement gemäß der Erfindung ist mit den Merkmalen des Anspruchs 1 definiert, eine Bauelementanordnung gemäß der Erfindung ist mit den Merkmalen des Anspruchs 11 definiert und ein Verfahren zur Herstellung eines keramischen Bauelements gemäß der Erfindung ist mit den Merkmalen des Anspruchs 13 definiert. Gemäß einem ersten Aspekt der vorliegenden Erfindung wird ein keramisches Bauelement aufweisend einen Grundkörper und einen am Grundkörper befestigten elektrischen Anschlusskontakt angegeben. Der Anschlusskontakt dient vorzugsweise zum elektrischen Anschluss des Bauelements an einem Träger. Beispielsweise dient der Anschlusskontakt zur Zuführung elektrischer Spannung und elektrischer Signale zum Bauelement. Weiterhin kann der Anschlusskontakt auch zur Herstellung einer mechanischen Befestigung und gegebenenfalls einer thermischen Verbindung zum Träger dienen.

Das keramische Bauelement ist vorzugsweise als Vielschichtbauelement ausgebildet. Beispielsweise weist der Grundkörper übereinander angeordnete keramischen Schichten und Elektrodenschichten auf. Die Schichten sind vorzugsweise gemeinsam gesintert. Insbesondere kann es sich um einen Kondensator, vorzugsweise um einen Leistungskondensator handeln. Das keramische Bauelement ist beispielsweise ein keramischer Vielschichtkondensator.

Vorzugsweise ist der Anschlusskontakt aus einem Blech gebildet. Dabei wird beispielsweise aus einem planaren Blech zuerst ein planares Stück mit den Abmessungen des Anschlusskontakts, beispielsweise durch Ausstanzen, gebildet. Anschließend wird der Anschlusskontakt vorzugsweise in eine gebogene Form gebracht. Beispielsweise weist der Anschlusskontakt eine gewinkelte Form auf. Es kann sich beim Anschlusskontakt auch um einen Leadframe handeln.

Beispielsweise weist der Anschlusskontakt wenigstens einen Kontaktbereich zur Befestigung des Anschlusskontakts an einem Grundkörper des keramischen Bauelements auf. Weiterhin weist der Anschlusskontakt beispielsweise wenigstens einen Anschlussbereich zur Befestigung an einem Träger, insbesondere an einer Leiterplatte, auf. Der Anschlussbereich ist vorzugsweise zum Kontaktbereich in einem Winkel angeordnet. Beispielsweise ist der Anschlussbereich nach außen oder nach innen gebogen.

In einer Ausführungsform weist der Anschlusskontakt zwei Anschlusselemente auf. Die Anschlusselemente sind vorzugsweise zur Befestigung an gegenüberliegenden Seiten des Grundkörpers ausgebildet. Die Eigenschaften des Anschlusskontakts gelten vorzugsweise entsprechend für jedes einzelne Anschlusselement.

Der Anschlusskontakt weist einen Materialverbund auf. Die Materialien sind dabei in Form von Schichten übereinander angeordnet. Erfindungsgemäß weist der Anschlusskontakt ein erstes Material und ein darauf angeordnetes zweites Material auf. Das erste Material ist als erste Schicht und das zweite Material als zweite Schicht ausgebildet.

Das erste Material weist eine große elektrische Leitfähigkeit auf. Die elektrische Leitfähigkeit liegt bei mindestens 40 m/(Ω·mm²), vorzugsweise bei mindestens 50 m/(Ω·mm²). Vorzugsweise weist das erste Material auch eine große thermische Leitfähigkeit auf. Eine große thermische Leitfähigkeit liegt beispielsweise bei mindestens 250 W/(m-K), vorzugsweise bei mindestens 350 W/(m·K).

Das zweite Material weist vorzugsweise besonders gute mechanische und thermomechanische Eigenschaften auf. Erfindungsgemäß weist das zweite Material einen kleinen thermischen Ausdehnungskoeffizienten bei höchstens 2,5 ppm/K auf. Der Ausdehnungskoeffizient liegt vorzugsweise möglichst nahe am Ausdehnungskoeffizienten der Keramik. Auf diese Weise kann eine gute thermische Anpassung an die Keramik erreicht werden. Dadurch kann ein Spannungsaufbau bei Temperaturwechseln größtenteils vermieden und eine Rissbildung im Bauelement weitgehend verhindert werden.

In einer bevorzugten Ausführungsform weist das erste Material Kupfer auf oder besteht aus Kupfer. Kupfer weist eine besonders gute elektrische und thermische Leitfähigkeit auf.

Beispielsweise weist das zweite Material eine eisenhaltige Legierung auf. Vorzugsweise weist das zweite Material Invar auf oder besteht aus Invar. Als Invar wird eine Eisen-NickelLegierung mit ca. 1/3 Nickel und 2/3 Eisen bezeichnet. Dieses Material weist einen besonders niedrigen thermischen Ausdehnungskoeffizienten auf. Insbesondere liegt der thermische Ausdehnungskoeffizient nahe am Ausdehnungskoeffizienten der Keramik. Aufgrund der Kombination mit dem ersten Material kann auch bei einer geringen elektrischen Leitfähigkeit des zweiten Materials eine ausreichende Leitfähigkeit für den Anschlusskontakt gewährleistet werden.

In einer Ausführungsform weist der Anschlusskontakt zudem ein drittes Material auf. Das dritte Material ist auf dem zweiten Material angeordnet, so dass das zweite Material zwischen dem ersten und dem dritten Material angeordnet ist. Das dritte Material ist vorzugsweise als dritte Schicht ausgebildet. Vorzugsweise ist das dritte Material gleich dem ersten Material. Vorzugsweise weist die dritte Schicht die gleiche Dicke auf wie die erste Schicht. Durch Ausbildung des dritten Materials kann vorzugsweise eine Verbiegung des Anschlusskontakts bei einer Temperaturänderung verhindert werden.

Insbesondere kann der Anschlusskontakt einen Materialverbund aus Kupfer-Invar-Kupfer aufweisen. Ein derartiger Verbund kann auch als CIC-Verbund bezeichnet werden.

Beispielsweise weist der Anschlusskontakt zwei Kontaktelemente auf, die an gegenüberliegenden Seiten des Grundkörpers angeordnet sind. Der Grundkörper weist beispielsweise einen Außenkontakt auf, an dem der Anschlusskontakt befestigt ist. Der Außenkontakt ist beispielsweise als Metallschicht, insbesondere als gesputterte Metallschicht, ausgebildet.

Erfindungsgemäß ist der Anschlusskontakt durch ein Kontaktmaterial am Grundkörper befestigt. Das Kontaktmaterial ist ein Sintermaterial, insbesondere Sintersilber. Zur Befestigung des Anschlusskontakts am Grundkörper wird das Kontaktmaterial beispielsweise auf den Grundkörper und/oder den Anschlusskontakt aufgetragen. Anschließend wird der Anschlusskontakt am Grundkörper angeordnet und das Kontaktmaterial gesintert. Auf diese Weise kann eine hochtemperaturfeste und niederohmige Verbindung zwischen dem Grundkörper und dem Anschlusskontakt erzielt werden.

In einer Ausführungsform ist das Bauelement derart ausgebildet, dass bei einer Befestigung des Anschlusskontakts am Träger der Grundkörper vom Träger beabstandet ist. Auf diese Weise kann eine thermische und mechanische Entkopplung des Grundkörpers vom Träger erreicht werden. Beispielsweise ist der Grundkörper in Höhenrichtung derart unzentriert am Anschlusskontakt angeordnet, dass ein Luftspalt zu einem Träger ausgebildet wird.

Gemäß einem weiteren Aspekt der vorliegenden Erfindung wird eine Bauelementanordnung aufweisend ein keramisches Bauelement und ein Träger, an dem das Bauelement befestigt ist, angegeben. Das Bauelement ist wie oben beschrieben ausgebildet und weist insbesondere den Anschlusskontakt auf. Der Träger ist beispielsweise als Leiterplatte ausgebildet. Es kann sich auch um einen keramischen Träger handeln.

Der Anschlusskontakt ist mit dem Träger beispielsweise durch ein Verbindungsmaterial verbunden. Das Verbindungsmaterial ist beispielsweise ein Lot- oder Sintermaterial. Insbesondere kann der Anschlusskontakt durch Sintern eines Sintermaterials mit dem Träger verbunden werden. Beispielsweise erfolgt das Sintern in einem Drucksinterverfahren oder einem drucklosen Sinterverfahren.

Gemäß einem weiteren Aspekt der vorliegenden Erfindung wird ein Verfahren zur Herstellung des vorhergehend beschriebenen e keramischen Bauelements angegeben. Der Anschlusskontakt ist wie oben beschrieben ausgebildet.

Bei der Herstellung des Anschlusskontakts wird beispielsweise ein Blech aufweisend das zweite Material bereitgestellt. Das zweite Material weist vorzugsweise Invar auf oder besteht aus Invar. Auf das zweite Material wird dann das erste Material aufgebracht, beispielsweise aufgewalzt. Das zweite Material weist vorzugsweise Kupfer auf oder besteht aus Kupfer. Anschließend kann das das dritte Material auf die gegenüberliegende Seite des Blechs aufgebracht, insbesondere aufgewalzt, werden. Das dritte Material ist vorzugsweise identisch mit dem ersten Material.

Danach kann der Anschlusskontakt in eine gewünschte Form gebracht werden. Beispielsweise werden die äußeren Abmessungen des Anschlusskontakts in einem Stanzprozess festgelegt. Anschließend wird das ausgestanzte Stück in eine gewünschte Form gebogen. Insbesondere kann dadurch eine gewinkelte Form des Anschlusskontakts gebildet werden.

Es wird ein Grundkörper des Bauelements bereitgestellt. Der Grundkörper ist wie oben beschrieben ausgebildet.

Anschließend wird der Anschlusskontakt am Grundkörper befestigt. Dazu wird ein Kontaktmaterial auf den Grundkörper und/oder den Anschlusskontakt aufgebracht. Das Kontaktmaterial ist als Sintermaterial ausgebildet. Anschließend wird der Anschlusskontakt am Grundkörper angeordnet und ein Sinterverfahren durchgeführt.

In der vorliegenden Offenbarung sind mehrere Aspekte einer Erfindung beschrieben. Alle Eigenschaften, die in Bezug auf den Anschlusskontakt, das Bauelement, die Bauelementanordnung und/oder eines der Verfahren offenbart sind, sind auch entsprechend in Bezug auf die jeweiligen anderen Aspekte offenbart und umgekehrt, auch wenn die jeweilige Eigenschaft nicht explizit im Kontext des jeweiligen Aspekts erwähnt wird.

Im Folgenden werden die hier beschriebenen Gegenstände anhand von schematischen und nicht maßstabsgetreuen Ausführungsbeispielen näher erläutert.

Es zeigen:
- Figur 1A: eine Ausführungsform einer Bauelementanordnung in einer schematischen Schnittansicht,
- Figuren 1B und 1C: Detailansichten der Bauelementanordnung aus Figur 1A,
- Figuren 2 bis 5: verschiedene Ausführungsformen von Bauelementen in perspektivischen Ansichten.

Vorzugsweise verweisen in den folgenden Figuren gleiche Bezugszeichen auf funktionell oder strukturell entsprechende Teile der verschiedenen Ausführungsformen.

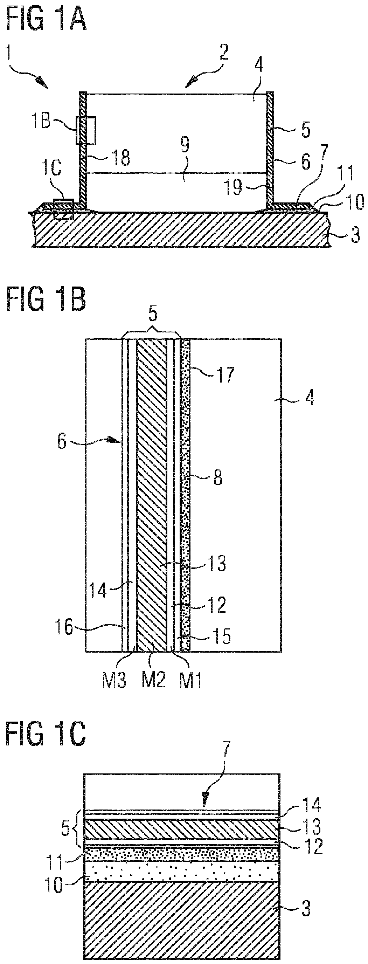

Figur 1A zeigt eine Bauelementanordnung 1 aufweisend ein elektrisches Bauelement 2 und einen Träger 3, auf dem das Bauelement 2 angeordnet ist.

Das elektrische Bauelement 2 weist einen Grundkörper 4 auf. Der Grundkörper 4 weist ein keramisches Material auf und wird somit als keramisches Bauelement bezeichnet. Das Bauelement 2 ist beispielsweise als Vielschichtbauelement ausgebildet. Insbesondere kann der Grundkörper 4 einen Schichtstapel mit keramischen Schichten und dazwischen angeordneten Elektrodenschichten aufweisen. Alle Schichten sind vorzugsweise gemeinsam gesintert. Beispielsweise weisen die Elektrodenschichten Kupfer auf. Beispielsweise ist das Bauelement 2 als Kondensator, insbesondere als keramischer Vielschichtkondensator ausgebildet. Es kann sich insbesondere um einen Leistungskondensator handeln.

Das Bauelement 2 weist einen Anschlusskontakt 5 zum elektrischen Anschluss des Bauelements 2 auf. Beispielsweise weist der Anschlusskontakt 5 zwei Anschlusselemente 18, 19 auf. Die Anschlusselemente 18, 19 sind beispielsweise auf gegenüberliegenden Seiten des Grundkörpers 4 angeordnet. Als Anschlusskontakt 5 kann auch nur eines der Anschlusselemente 18, 19 bezeichnet sein.

Der Anschlusskontakt 5 verbindet das Bauelement 2 elektrisch mit dem Träger 3. Weiterhin kann der Anschlusskontakt 5 auch zur mechanischen Befestigung des Bauelements 2 am Träger 3 dienen. Der Anschlusskontakt 5 kann auch eine thermische Anbindung an den Träger 3 gewährleisten.

Der Anschlusskontakt 5 wird vorzugsweise separat vom Grundkörper 4 hergestellt und anschließend am Grundkörper 4 befestigt. Vorzugsweise ist der Anschlusskontakt 5 aus einem Blech gebildet. Insbesondere kann es sich bei dem Anschlusskontakt 5 um einen Anschlusswinkel oder Leadframe handeln. Der Anschlusskontakt 5 weist vorzugsweise neben einer hohen thermischen und elektrischen Leitfähigkeit einen möglichst geringen thermischen Ausdehnungskoeffizienten auf. Diese unterschiedlichen Eigenschaften werden durch einen Materialverbund, insbesondere durch einen mehrschichtigen Aufbau des Anschlusskontakts 5 gewährleistet. Der Aufbau des Anschlusskontakts 5 ist in Zusammenhang mit Figur 1B im Detail beschrieben.

Der Anschlusskontakt 5 weist einen Kontaktbereich 6 zur Befestigung am Grundkörper 4 und einen Anschlussbereich 7 zur Befestigung am Träger 3 auf. Der Kontaktbereich 6 ist beispielsweise mittels eines Kontaktmaterials 8 am Grundkörper 4 befestigt. Beispielsweise ist das Kontaktmaterial 8 schichtförmig angeordnet. Beispielsweise handelt es sich bei dem Kontaktmaterial 8 um ein Sintermaterial. Der Anschlusskontakt 5 ist vorzugsweise durch Sintern des Sintermaterials 8 am Grundkörper 4 befestigt. Beispielsweise wird hier ein Niedertemperatur-Sinterprozess, insbesondere bei einer Temperatur im Bereich von 250°C, durchgeführt.

Der Anschlussbereich 7 ist zum Kontaktbereich 6 in einem Winkel angeordnet. Beispielsweise ist der Anschlussbereich 7 in einem Winkel von 90° zum Kontaktbereich 6 orientiert. Der Anschlussbereich 7 kann nach außen oder nach innen gebogen sein. Bei einem nach innen gebogenen Anschlussbereich 7 liegt der Anschlussbereich 7 vorzugsweise unterhalb des Grundkörpers 4. Bei einem nach außen gebogenen Anschlussbereich 7 liegt der Anschlussbereich 7 vorzugsweise neben dem Grundkörper 4. Der Anschlusskontakt 5 ist vorzugsweise derart ausgebildet, dass der Grundkörper 4 in einem Abstand vom Träger 3 angeordnet ist. Insbesondere befindet sich zwischen dem Grundkörper 4 und dem Träger 3 ein Luftspalt 9.

Bei dem Träger 3 handelt es sich beispielsweise um eine Leiterplatte. Beispielsweise ist die Leiterplatte als FR4-Platine ausgebildet. Es kann sich auch um ein keramisches Substrat handeln. Beispielsweise ist der Träger 3 als DCB (direct copper bonded)-Substrat ausgebildet, bei dem Kupfer auf eine Keramik aufgebracht ist.

Der Träger 3 weist wenigstens eine Kontaktstelle 10 auf, an dem der Anschlussbereich 7 des Anschlusskontakts 5 befestigt wird. Beispielsweise handelt es sich bei der Kontaktstelle 10 um ein Lötpad oder einen Kupfer-Kontakt. Beispielsweise ist der Anschlussbereich 7 mit der Kontaktstelle 10 verlötet oder versintert. Dazu ist beispielsweise ein Verbindungsmaterial 11 in Form eines Lot- oder Sintermaterials vorgesehen.

Figur 1B zeigt einen vergrößerten Ausschnitt aus Figur 1A, dessen Position mit "1B" in Figur 1A eingezeichnet ist. Insbesondere ist der mehrschichtige Aufbau des Anschlusskontakts 5 zu sehen. Der Anschlusskontakt 5 weist wenigstens ein erstes Material M1 und ein darauf angeordnetes zweites Material M2 auf. Das erste Material M1 unterscheidet sich vom zweiten Material M2. Insbesondere sind die Materialien M1, M2 als eine erste Schicht 12 und eine darauf angeordnete zweite Schicht 13 ausgebildet. Die erste Schicht 12 ist näher am Grundkörper 4 angeordnet als die zweite Schicht 13.

Das erste Material M1 und somit die erste Schicht 12 weist eine besonders gute elektrische und vorzugsweise auch thermische Leitfähigkeit auf. Die erste Schicht 12 weist das erste Material M1 auf oder besteht aus dem ersten Material M1. Vorzugsweise handelt es sich beim ersten Material M1 um Kupfer. Kupfer weist eine spezifische elektrische Leitfähigkeit von ca. 58 m/(Ω·mm²), eine Wärmeleitfähigkeit von ca. 400 W/(m-K) und einen thermischen Ausdehnungskoeffizienten von ca. 18 ppm/K auf.

Das zweite Material M2 und somit die zweite Schicht 13 weist einen geringen thermischen Ausdehnungskoeffizienten auf. Weiterhin gewährleistet die zweite Schicht 13 beispielsweise die mechanische Festigkeit des Anschlusskontakts 5. Die zweite Schicht 13 weist das zweite Material M2 auf oder besteht aus dem zweiten Material M2. Beispielsweise handelt es sich dabei um Invar. Invar weist eine spezifische elektrische Leitfähigkeit von ca. 1,2 m/(Ω·mm²), eine wärmeleitfähigkeit von ca. 13 W/(m·K) und einen thermischen Ausdehnungskoeffizienten von < 2 ppm/K auf.

Somit weist das erste Material M1 eine wesentlich größere elektrische und thermische Leitfähigkeit auf als das zweite Material M2. Das zweite Material M1 weist einen wesentlich kleineren thermischen Ausdehnungskoeffizienten auf als das erste Material M1.

Der Anschlusskontakt 5 kann zudem ein drittes Material M3 aufweisen. Das dritte Material M3 kann dasselbe Material wie das erste Material M1 sein. Das dritte Material M3 bildet eine dritte Schicht 14, wobei die dritte Schicht 14 auf der zweiten Schicht 13 angeordnet ist. Die zweite Schicht 13 ist zwischen der ersten Schicht 12 und der dritten Schicht 14 angeordnet. Vorzugsweise weist die dritte Schicht 14 die gleiche Dicke wie die erste Schicht 12 auf. Durch die dritte Schicht 14 kann ein Bimetall-Verhalten des Anschlusskontakts 5 verhindert werden.

Beispielsweise weist der Anschlusskontakt 5 eine Dicke im Bereich zwischen 0,1 mm und 1 mm auf. Insbesondere kann die Dicke bei 0,15 mm liegen. Erfindungsgemäß verhält sich die Dicke der zweiten Schicht 13 zur Dicke der ersten Schicht 12 wie 1:1 bis zu 5:1. Insbesondere verhalten sich die Dicken wie 3:1. Bei einer Ausbildung einer dritten Schicht 14 verhält sich die Dicke der dritten Schicht 14 zur Dicke der zweiten Schicht 13 zur Dicke der ersten Schicht 12 beispielsweise wie 1:1:1 bis zu 1:5:1. Insbesondere verhalten sich die Dicken wie 1:3:1. Beispielsweise weist die zweite Schicht 13 Invar mit einer Dicke von 90 pm, die erste Schicht 12 Kupfer mit einer Dicke von 30 µm und die dritte Schicht 14 Kupfer mit einer Dicke von 30 µm auf. Der thermische Ausdehnungskoeffizient eines derartigen CIC Anschlusskontakts liegt abhängig vom gewählten Dickenverhältnis erfindungsgemäß im Bereich von ca. 5-7 ppm/K.

Der Anschlusskontakt 5 kann darüber hinaus ein oder mehrere weitere Schichten 15, 16 aufweisen. Die weiteren Schichten 15, 16 bilden beispielsweise die Außenseiten der Anschlusskontakt 5. Beispielsweise handelt es sich um Galvanikschichten 15, 16, insbesondere um Silberschichten. Die Galvanikschichten weisen beispielsweise jeweils eine Dicke im Bereich von 5 µm bis 10 µm auf. Die weiteren Schichten dienen beispielsweise zur Passivierung für die erste bzw. die dritte Schicht 12, 14. Insbesondere können diese Schichten einen Anlaufschutz bieten. Weiterhin können diese Schichten lötbare Oberflächen bereitstellen oder die Verbindung zu einem Sintermaterial verbessern.

Zur Herstellung des Anschlusskontakts 5 wird beispielsweise die zweite Schicht 13 bereitgestellt und anschließend darauf die erste Schicht 12 und gegebenenfalls die dritte Schicht 14 angeordnet. Die zweite Schicht 13 wird insbesondere als Blech bereitgestellt. Beispielsweise werden die erste und dritte Schicht 12, 14 auf die zweite Schicht 13 aufgewalzt. Anschließend werden beispielsweise beidseitig die Galvanikschichten 15, 16 aufgebracht. Aus dem mehrschichten Blech wird dann beispielsweise ein Stück herausgestanzt und in eine gewünschte Form gebogen.

Der Anschlusskontakt 5 ist vorzugsweise an einem Außenkontakt 17 des Grundkörpers 4 befestigt. Der Außenkontakt 17 ist in elektrischem Kontakt mit den Elektrodenschichten des Grundkörpers 4. Der Außenkontakt 17 weist beispielsweise wenigstens eine gesputterte Schicht auf. Der Außenkontakt 17 kann mehrere über einander angeordnete Schichten, insbesondere mehrere gesputterte Schichten aufweisen. Beispielsweise weist der Außenkontakt 17 Komponenten zur Haftvermittlung, zur Diffusionssperre und zur Weiterkontaktierung auf. In einer Ausführungsform handelt es sich um einen Cr/Ni/Ag-Schichtaufbau. Beispielsweise weist der Außenkontakt 17 eine Dicke im Bereich von 1 µm auf.

Der Anschlusskontakt 5 ist durch ein Kontaktmaterial 8 mit dem Außenkontakt 17 verbunden. Das Kontaktmaterial 8 weist vorzugsweise eine hohe elektrische und thermische Leitfähigkeit auf. Weiterhin weist das Kontaktmaterial 8 vorzugsweise eine hohe Robustheit gegenüber Temperaturwechsellasten und eine hohe Haftkraft auf. Erfindungsgemäß weist das Kontaktmaterial 8 ein Sintermaterial, insbesondere Sintersilber, auf. Der Anschlusskontakt 5 wird dann mit dem Grundkörper 4 durch Sintern des Kontaktmaterials 8 befestigt. Beispielsweise weist das Kontaktmaterial 8 eine Dicke im Bereich von 20 µm auf. Das Kontaktmaterial 8 ist beispielsweise wie die in der DE 10 2013 108 753 A1 beschriebene Kontaktschicht ausgebildet.

Zur Befestigung des Anschlusskontakts 5 am Grundkörper 4 wird beispielsweise das Kontaktmaterial 8 auf den Grundkörper 4 und/oder den Anschlusskontakt 5 aufgebracht. Der Anschlusskontakt 5, insbesondere die Anschlusselemente 18, 19 werden dann am Grundkörper 4 angeordnet und in einem Sinterverfahren befestigt. Beispielsweise wird auch hier ein Niedertemperatur-Sinterverfahren durchgeführt.

Figur 1C zeigt einen vergrößerten Ausschnitt aus Figur 1A, dessen Position mit "1C" in Figur 1A eingezeichnet ist. Insbesondere ist hier die Verbindung des Anschlusskontakts 5 mit einer Kontaktstelle 10 des Trägers 3 zu sehen. Der Träger 3 mit der Kontaktstelle 10 ist beispielsweise als Leiterplatte mit Kontaktpads oder als keramisches Substrat mit Kontaktflächen, insbesondere als DCB-Substrat ausgebildet.

In einer Ausführungsform wird die Befestigung durch eine Lötung realisiert. Beispielsweise wird hierzu als Verbindungsmaterial 11 ein bleifreies SAC-Lot verwendet. In einer alternativen Ausführungsform wird die Befestigung durch Sintern realisiert. Beispielsweise wird hierzu als Verbindungsmaterial 11 ein Sintersilber-Material verwendet. Es kann dabei drucklos gesintert oder druckgesintert werden. Die nach außen gebogenen Anschlussbereiche 7 ermöglichen dabei eine besonders gute Verbindung in einem Drucksinterprozess, da Druck direkt auf die Anschlussbereiche 7 ausgeübt werden kann, ohne dass eine Gefahr der Vorschädigung des Grundkörpers 4 oder des Außenkontakts 17 besteht.

Der Aufbau des Anschlusskontakts 5 in seinem Anschlussbereich 7 entspricht dem Aufbau in seinem Kontaktbereich 6. Insbesondere weist der Anschlusskontakt 5 einen mehrschichtigen Aufbau, beispielsweise einen CIC-Aufbau mit beidseitig aufgebrachten Galvanikschichten auf.

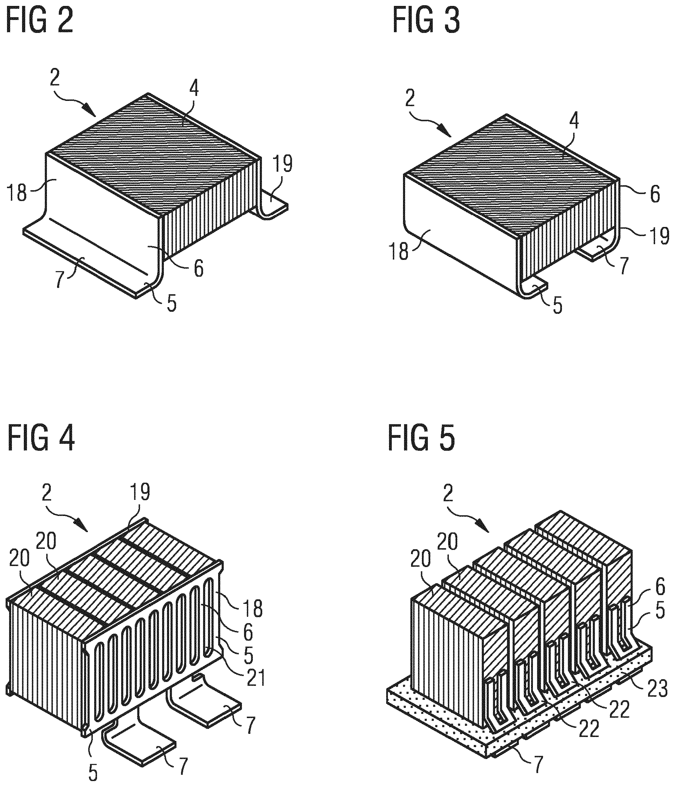

In den Figuren 2 bis 5 sind verschiedene Ausführungsformen von Anschlusskontakten 5 und Bauelementen 2 aufweisend die Anschlusskontakte 5 gezeigt. Die Anschlusskontakte 5 weisen jeweils den zu den Figuren 1A-1C beschriebenen Materialverbund auf. Alle Bauelemente 2 können in SMD-Montage, d.h., Oberflächenmontage, an einem Träger befestigt werden.

In Figur 2 ist ein Anschlusskontakt 5 in derselben Ausführungsform wie der Anschlusskontakt 5 aus den Figuren 1A-1C gezeigt.

Insbesondere weist der Anschlusskontakt 5 zwei Anschlusselemente 18, 19 auf, die an gegenüberliegenden Seiten eines Grundkörpers 4 eines Bauelements 2 angeordnet sind. Die Anschlusselemente 18, 19 weisen jeweils einen Kontaktbereich 6 und einen nach außen gebogenen Anschlussbereich 7 auf. Somit führt der Anschlussbereich 7 vom Grundkörper 4 weg. Bei einer derartigen Geometrie kann der Anschlusskontakt 5 besonders gut in einem DruckSinterprozess an einem Träger 3 befestigt werden.

Der Grundkörper 4 weist eine Quaderform auf. Der Anschlusskontakt 5 erstreckt sich vollständig über zwei Längsseiten des Grundkörpers 4. Der Anschlusskontakt 4 kann sich auch nur teilweise über Außenseiten des Grundkörpers erstrecken. Zwischen einer Unterseite des Grundkörpers 4 und eines Unterseite des Anschlussbereichs 7 ist ein deutlicher Höhenunterschied, so dass der Grundkörper 4 mit einem Abstand zum Träger 3 angeordnet werden kann.

In Figur 3 ist eine weitere Ausführungsform eines Anschlusskontakts 5 und eines Bauelements 2 aufweisend den Anschlusskontakt 5 gezeigt. Im Unterschied zum Anschlusskontakt 5 aus Figur 2 ist der Anschlussbereich 7 hier nach innen gebogen. Der Anschlussbereich 7 ist unterhalb des Grundkörpers 4 angeordnet. Auch hier befindet sich zwischen einer Unterseite des Grundkörpers 4 und einer Unterseite des Anschlussbereichs 7 ein Luftspalt 9. Der Grundkörper 4 ist somit in Höhenrichtung nicht zentriert zum Anschlusskontakt 5 angeordnet.

In Figur 4 ist eine weitere Ausführungsform eines Anschlusskontakts 5 und eines Bauelements 2 aufweisend den Anschlusskontakt 5 gezeigt. Das Bauelement 2 weist einen Grundkörper 4 mit mehreren Teilkörpern 20 auf. Beispielsweise sind fünf Teilkörper 20 vorgesehen. Der Anschlusskontakt 5 weist zwei Anschlusselemente 18, 19 auf. Über den Anschlusskontakt 5 wird ein gemeinsamer elektrischer Kontakt für alle Teilkörper 20 hergestellt. Somit sind die Teilkörper 20 parallel geschaltet.

Die Anschlusselemente 18, 19 weisen jeweils mehrere Anschlussbereiche 7 zur Befestigung an einem Träger auf. Dies ermöglicht eine stabile Befestigung auch bei einer größeren Bauform. Die Anschlussbereiche 7 sind nach außen gebogen.

Im Kontaktbereich 6 sind Aussparungen 21 vorgesehen. Der Kontaktbereich 6 erstreckt sich über eine gesamte Längsseite des Grundkörpers 4.

In Figur 5 ist eine weitere Ausführungsform eines Anschlusskontakts 5 und eines Bauelements 2 aufweisend den Anschlusskontakt 5 gezeigt. Das Bauelement 2 weist wie in Figur 4 einen Grundkörper 4 mit mehreren Teilkörpern 20 auf.

Das Bauelement 2 ist in Form eines variablen "Endlos"-Designs ausgebildet. Insbesondere kann das Bauelement 2 beliebig viele Teilkörper 20 aufweisen und anschließend in kleinere Bauelemente 2 zerlegt werden. Dazu weist der Anschlusskontakt 5 beispielsweise eine separierbare Form auf. Insbesondere weist der Anschlusskontakt 5 eine Vielzahl von Teilanschlüssen 22 auf, die jeweils einen Teilkörper 20 kontaktieren. Jeder Teilanschluss 22 weist einen Kontaktbereich 6 zur Kontaktierung eines Teilkörpers auf. Die Kontaktbereiche 6 weisen jeweils zwei Kontaktarme auf, die an einem Teilkörper 20 anliegen. Die Anschlusskontakte 5 sind beispielsweise federnd ausgebildet. Die Teilanschlüsse 22 können durch dünne Stege (nicht gezeigt) miteinander verbunden sein. Durch Durchbrechen der Stege können die Teilanschlüsse 22 vereinzelt werden.

Zur Erhöhung der mechanischen Stabilität weist das Bauelement 2 einen Sockel 23, beispielsweise einen Kunststoffsockel auf, auf dem der Grundkörper 4 angeordnet ist. Der Anschlusskontakt 5 ist durch den Sockel 23 hindurchgeführt. Alternativ kann der Anschlusskontakt 5 auch um eine Schmalseite des Sockels 23 herumgeführt sein.

### Bezugszeichenliste

- 1: Bauelementanordnung
- 2: Bauelement
- 3: Träger
- 4: Grundkörper
- 5: Anschlusskontakt
- 6: Kontaktbereich
- 7: Anschlussbereich
- 8: Kontaktmaterial
- 9: Luftspalt
- 10: Kontaktstelle
- 11: Verbindungsmaterial
- 12: erste Schicht
- 13: zweite Schicht
- 14: dritte Schicht
- 15: weitere Schicht
- 16: weitere Schicht
- 17: Außenkontakt
- 18: Anschlusselement
- 19: Anschlusselement
- 20: Teilkörper
- 21: Aussparung
- 22: Teilanschluss
- 23: Sockel

- M1: erstes Material
- M2: zweites Material
- M3: drittes Material

## Patentansprüche

1. Keramisches Bauelement,
aufweisend einen Grundkörper (4) und einen elektrischen Anschlusskontakt (5),
wobei der Anschlusskontakt (5) eine erste Schicht (12) aufweisend ein erstes Material (M1) und eine darauf angeordnete zweite Schicht (13) aufweisend ein zweites Material (M2) aufweist, wobei das erste Material (M1) eine große elektrische Leitfähigkeit und das zweite Material (M2) einen kleinen thermischen Ausdehnungskoeffizienten aufweist, wobei die elektrische Leitfähigkeit des ersten Materials (M1) bei mindestens 40 m/Ωmm² und der thermische Ausdehnungskoeffizient des zweiten Materials (M2) bei höchstens 2,5 ppm/K liegt,
wobei der thermische Ausdehnungskoeffizient des zweiten Materials (M2) kleiner ist als der thermische Ausdehnungskoeffizient des ersten Materials (M1),
wobei sich die Dicke der zweiten Schicht (13) zur Dicke der ersten Schicht (12) wie 1:1 bis 5:1 verhält,
wobei der thermische Ausdehnungskoeffizient des Anschlusskontaktes als Ganzes zwischen 5 und 7 ppm/K liegt, und aufweisend ein gesintertes Kontaktmaterial (8), das den Anschlusskontakt (5) am Grundkörper (4) befestigt.

2. Keramisches Bauelement nach Anspruch 1,
bei dem das erste Material (M1) Kupfer und das zweite Material (M2) Invar aufweist.

3. Keramisches Bauelement nach einem der vorhergehenden Ansprüche, bei dem der Anschlusskontakt aus einem Blech gebildet ist.

4. Keramisches Bauelement nach einem der vorhergehenden Ansprüche,
aufweisend eine dritte Schicht aufweisend ein drittes Material (M3), die auf der zweiten Schicht (13) angeordnet ist, wobei die zweite Schicht (13) zwischen der ersten und der dritten Schicht (12, 14) angeordnet ist.

5. Keramisches Bauelement nach Anspruch 4,
wobei das dritte Material (M3) gleich ist wie das erste Material (M1) und wobei die dritte Schicht (14) die gleiche Dicke aufweist wie die erste Schicht (13).

6. Keramisches Bauelement nach einem der vorhergehenden Ansprüche,
aufweisend wenigstens einen Kontaktbereich (6) zur Befestigung des Anschlusskontakts (5) an einem keramischen Bauelement (2) und wenigstens einen Anschlussbereich (7) zur Befestigung des Anschlusskontakts (5) an einem Träger (3), wobei der Anschlussbereich (7) zum Kontaktbereich (6) in einem Winkel angeordnet ist.

7. Keramisches Bauelement nach einem der vorhergehenden Ansprüche,
bei dem der Anschlusskontakt (5) mehrere separate, nebeneinander angeordnete Anschlussbereiche (7) zur Befestigung des Anschlusskontakts (5) an einem Träger (3) aufweist.

8. Keramisches Bauelement nach einem der vorhergehenden Ansprüche,
wobei das Kontaktmaterial (8) Sintersilber ist.

9. Keramisches Bauelement nach einem der vorhergehenden Ansprüche,
das derart ausgebildet ist, dass bei einer Befestigung des Anschlusskontakts (5) an einem Träger (3) der Grundkörper (4) vom Träger (3) beabstandet ist.

10. Keramisches Bauelement nach einem der vorhergehenden Ansprüche,
das als Vielschichtkondensator ausgebildet ist.

11. Bauelementanordnung
mit einem keramischen Bauelement (2) nach einem der vorhergehenden Ansprüche und einem Träger (3), an dem das Bauelement (2) befestigt ist.

12. Bauelementanordnung nach Anspruch 11,
bei dem der Anschlusskontakt (5) mit dem Träger (3) durch ein Verbindungsmaterial (11) verbunden ist, wobei das Verbindungsmaterial (11) ein Lot- oder Sintermaterial ist.

13. Verfahren zur Herstellung des keramischen Bauelements nach einem der vorhergehenden Ansprüche, aufweisend die Schritte
A) Bereitstellen des Anschlusskontakts (5) und eines Grundkörpers (4) des Bauelements (2),
wobei der Anschlusskontakt (5) eine erste Schicht (12) aufweisend ein erstes Material (M1) und eine darauf angeordnete zweite Schicht (13) aufweisend ein zweites Material (M2) aufweist, wobei das erste Material (M1) eine große elektrische Leitfähigkeit und das zweite Material (M2) einen kleinen thermischen Ausdehnungskoeffizienten aufweist, wobei die elektrische Leitfähigkeit des ersten Materials (M1) bei mindestens 40 m/Ωmm² und der thermische Ausdehnungskoeffizient des zweiten Materials (M2) bei höchstens 2,5 ppm/K liegt,
wobei der thermische Ausdehnungskoeffizient des zweiten Materials (M2) kleiner ist als der thermische Ausdehnungskoeffizient des ersten Materials (M1),
wobei sich die Dicke der zweiten Schicht (13) zur Dicke der ersten Schicht (12) wie 1:1 bis 5:1 verhält wobei der thermische Ausdehnungskoeffizient des Anschlusskontaktes als Ganzes zwischen 5 und 7 ppm/K liegt,
B) Befestigen des Anschlusskontakts (5) am Grundkörper (4), wobei zur Befestigung des Anschlusskontakts (5) ein Kontaktmaterial (8) auf den Grundkörper (4) und/oder den Anschlusskontakt (5) aufgebracht wird, dann der Anschlusskontakt (5) am Grundkörper (4) angeordnet wird und dann das Kontaktmaterial (8) gesintert wird.

14. Verfahren zur Herstellung des keramischen Bauelements nach Anspruch 13, wobei die Herstellung des Anschlusskontakts (5) die folgenden Schritte aufweist:
A) Bereitstellen eines Blechs aufweisend das zweite Material (M2),
B) Aufwalzen des ersten Materials (M1) auf das zweite Material (M2).

## Claims

1. Ceramic component,
having a main body (4) and an electrical connection contact (5),
wherein the connection contact (5) has a first layer (12) containing a first material (M1) and a second layer (13), which is arranged on the said first layer, containing a second material (M2), wherein the first material (M1) has a high electrical conductivity and the second material (M2) has a low coefficient of thermal expansion, wherein the electrical conductivity of the first material (M1) is at least 40 m/Ωmm² and the coefficient of thermal expansion of the second material (M2) is at most 2.5 ppm/K,
wherein the coefficient of thermal expansion of the second material (M2) is lower than the coefficient of thermal expansion of the first material (M1),
wherein the thickness of the second layer (13) is in a ratio of 1:1 to 5:1 in relation to the thickness of the first layer (12),
wherein the coefficient of thermal expansion of the connection contact is between 5 and 7 ppm/K as a whole, and containing a sintered contact material (8) which fastens the connection contact (5) to the main body (4).

2. Ceramic component according to Claim 1,
in which the first material (M1) contains copper and the second material (M2) contains Invar.

3. Ceramic component according to either of the preceding claims,
in which the connection contact is formed from a metal plate.

4. Ceramic component according to one of the preceding claims,
having a third layer containing a third material (M3) which is arranged on the second layer (13), wherein the second layer (13) is arranged between the first layer (12) and the third layer (14).

5. Ceramic component according to Claim 4,
wherein the third material (M3) is the same as the first material (M1), and wherein the third layer (14) has the same thickness as the first layer (13).

6. Ceramic component according to one of the preceding claims,
having at least one contact region (6) for fastening the connection contact (5) to a ceramic component (2) and at least one connection region (7) for fastening the connection contact (5) to a carrier (3), wherein the connection region (7) is arranged at an angle in relation to the contact region (6).

7. Ceramic component according to one of the preceding claims,
in which the connection contact (5) has a plurality of separate connection regions (7), which are arranged next to one another, for fastening the connection contact (5) to a carrier (3).

8. Ceramic component according to one of the preceding claims,
wherein the contact material (8) is sintered silver.

9. Ceramic component according to one of the preceding claims,
which is designed in such a way that, when the connection contact (5) is fastened to a carrier (3), the main body (4) is at a distance from the carrier (3).

10. Ceramic component according to one of the preceding claims,
which is designed as a multilayer capacitor.

11. Component arrangement
comprising a ceramic component (2) according to one of the preceding claims and a carrier (3) to which the component (2) is fastened.

12. Component arrangement according to Claim 11,
in which the connection contact (5) is connected to the carrier (3) by a connecting material (11), wherein the connecting material (11) is a soldering or sintering material.

13. Method for producing the ceramic component according to one of the preceding claims, comprising the steps of
A) providing the connection contact (5) and a main body (4) of the component (2),
wherein the connection contact (5) has a first layer (12) containing a first material (M1) and a second layer (13), which is arranged on the said first layer, containing a second material (M2), wherein the first material (M1) has a high electrical conductivity and the second material (M2) has a low coefficient of thermal expansion, wherein the electrical conductivity of the first material (M1) is at least 40 m/Ωmm² and the coefficient of thermal expansion of the second material (M2) is at most 2.5 ppm/K,
wherein the coefficient of thermal expansion of the second material (M2) is lower than the coefficient of thermal expansion of the first material (M1),
wherein the thickness of the second layer (13) is in a ratio of 1:1 to 5:1 in relation to the thickness of the first layer (12), wherein the coefficient of thermal expansion of the connection contact is between 5 and 7 ppm/K as a whole,
B) fastening the connection contact (5) to the main body (4), wherein, for fastening the connection contact (5), a contact material (8) is applied to the main body (4) and/or to the connection contact (5), the connection contact (5) is then arranged on the main body (4) and the contact material (8) is then sintered.

14. Method for producing the ceramic component according to Claim 13, wherein producing the connection contact (5) comprises the following steps:
A) providing a metal plate containing the second material (M2),
B) rolling the first material (M1) onto the second material (M2).

## Revendications

1. Composant céramique, comprenant un corps de base (4) et un contact de connexion électrique (5),
le contact de connexion (5) comprenant une première couche (12) comprenant un premier matériau (M1) et une deuxième couche (13), agencée sur celle-ci, comprenant un deuxième matériau (M2), le premier matériau (M1) présentant une conductivité électrique élevée et le deuxième matériau (M2) présentant un coefficient de dilatation thermique faible, la conductivité électrique du premier matériau (M1) étant d'au moins 40 m/Ωmm² et le coefficient de dilatation thermique du deuxième matériau (M2) étant d'au plus 2,5 ppm/K,
le coefficient de dilatation thermique du deuxième matériau (M2) étant inférieur au coefficient de dilatation thermique du premier matériau (M1),
le rapport entre l'épaisseur de la deuxième couche (13) et l'épaisseur de la première couche (12) étant de 1:1 à 5:1,
le coefficient de dilatation thermique du contact de connexion dans son ensemble étant compris entre 5 et 7 ppm/K,
et comprenant un matériau de contact fritté (8), qui fixe le contact de connexion (5) sur le corps de base (4) .

2. Composant céramique selon la revendication 1, dans lequel le premier matériau (M1) comprend du cuivre et le deuxième matériau (M2) comprend de l'Invar.

3. Composant céramique selon l'une quelconque des revendications précédentes, dans lequel le contact de connexion est formé à partir d'une tôle.

4. Composant céramique selon l'une quelconque des revendications précédentes, comprenant une troisième couche comprenant un troisième matériau (M3), qui est agencée sur la deuxième couche (13), la deuxième couche (13) étant agencée entre la première et la troisième couche (12, 14).

5. Composant céramique selon la revendication 4, dans lequel le troisième matériau (M3) est identique au premier matériau (M1) et dans lequel la troisième couche (14) présente la même épaisseur que la première couche (13).

6. Composant céramique selon l'une quelconque des revendications précédentes, comprenant au moins une zone de contact (6) pour la fixation du contact de connexion (5) sur un composant céramique (2) et au moins une zone de connexion (7) pour la fixation du contact de connexion (5) sur un support (3), la zone de connexion (7) étant agencée à un angle par rapport à la zone de contact (6).

7. Composant céramique selon l'une quelconque des revendications précédentes, dans lequel le contact de connexion (5) comprend plusieurs zones de connexion (7) séparées, agencées les unes à côté des autres, pour la fixation du contact de connexion (5) sur un support (3) .

8. Composant céramique selon l'une quelconque des revendications précédentes, dans lequel le matériau de contact (8) est de l'argent fritté.

9. Composant céramique selon l'une quelconque des revendications précédentes, qui est configuré de telle sorte que, lors d'une fixation du contact de connexion (5) sur un support (3), le corps de base (4) est espacé du support (3).

10. Composant céramique selon l'une quelconque des revendications précédentes, qui est configuré sous la forme d'un condensateur à plusieurs couches.

11. Agencement de composant, muni d'un composant céramique (2) selon l'une quelconque des revendications précédentes et d'un support (3), sur lequel le composant (2) est fixé.

12. Agencement de composant selon la revendication 11, dans lequel le contact de connexion (5) est relié avec le support (3) par un matériau de liaison (11), le matériau de liaison (11) étant un matériau de brasage ou de frittage.

13. Procédé de fabrication du composant céramique selon l'une quelconque des revendications précédentes, comprenant les étapes suivantes :
A) la fourniture du contact de connexion (5) et d'un corps de base (4) du composant (2),
le contact de connexion (5) comprenant une première couche (12) comprenant un premier matériau (M1) et une deuxième couche (13), agencée sur celle-ci, comprenant un deuxième matériau (M2), le premier matériau (M1) présentant une conductivité électrique élevée et le deuxième matériau (M2) présentant un coefficient de dilatation thermique faible, la conductivité électrique du premier matériau (M1) étant d'au moins 40 m/Ωmm² et le coefficient de dilatation thermique du deuxième matériau (M2) étant d'au plus 2,5 ppm/K,
le coefficient de dilatation thermique du deuxième matériau (M2) étant inférieur au coefficient de dilatation thermique du premier matériau (M1),
le rapport entre l'épaisseur de la deuxième couche (13) et l'épaisseur de la première couche (12) étant de 1:1 à 5:1, le coefficient de dilatation thermique du contact de connexion dans son ensemble étant compris entre 5 et 7 ppm/K,
B) la fixation du contact de connexion (5) sur le corps de base (4), un matériau de contact (8) étant appliqué sur le corps de base (4) et/ou le contact de connexion (5) pour la fixation du contact de connexion (5), puis le contact de connexion (5) étant agencé sur le corps de base (4), et ensuite le matériau de contact (8) étant fritté.

14. Procédé de fabrication du composant céramique selon la revendication 13, dans lequel la fabrication du contact de connexion (5) comprend les étapes suivantes :
A) la fourniture d'une tôle comprenant le deuxième matériau (M2),
B) le cylindrage du premier matériau (M1) sur le deuxième matériau (M2).
